# EUROPÄISCHE PATENTSCHRIFT

(11) **EP 0 545 115 B1**
(45) Veröffentlichungstag und Bekanntmachung des Hinweises auf die Patenterteilung: **28.02.1996**
(21) Anmeldenummer: 92119404.9
(22) Anmeldetag: 13.11.1992
(51) Int. Cl.: H05K 5/04

(54) **Steuergehäuse für die Aufnahme elektrischer, elektronischer und mechanischer Bauteile**
Control housing for electric, electronic, and mechanical components
Boîtier de contrôle pour composants électriques, électroniques et mécaniques

(30) Priorität: 29.11.1991 DE 4139341
(43) Veröffentlichungstag der Anmeldung: 09.06.1993
(73) Patentinhaber: Rose-Elektrotechnik GmbH + Co KG Elektrotechnische Fabrik, D-32457 Porta Westfalica (DE)
(72) Erfinder: Pohlmann, Franz F., W-4950 Minden (DE); Seligmann, Heinfred, W-3079 Uchte (DE)
(74) Vertreter: Hanewinkel, Lorenz, Dipl.-Phys.

(56) Entgegenhaltungen:
- DE-A- 1 929 725
- DE-B- 1 094 332
- GB-A- 2 211 026
- US-A- 3 901 571

## Beschreibung

Die Erfindung bezieht sich auf ein Steuergehäuse für die Aufnahme elektrischer, elektronischer und mechanischer Bauteile, welches aus mindestens einem Grundgehäuse, das vier Wandungen und diese zusammenhaltende Eckverbinder aufweist, und mindestens einer am Grundgehäuse fest oder schwenkbar angebrachten Tür (Rahmen) besteht.

Ein derartiges Steuergehäuse ist aus der CH-PS 677 855 bekannt geworden, bei dem die plattenförmigen Wandungen des Steuergehäuses durch besonders gestaltete Eckverbinder zusammengehalten werden.

Hierbei sind die plattenförmigen Wandungen immer in einer gewissen Breite ausgeführt, so daß durch diese Wandungen die jeweilige Gehäusetiefe festgelegt ist und für unterschiedlich tiefe Steuergehäuse müssen somit auch unterschiedlich breite plattenförmige Wandungen erstellt werden.

Weiterhin offenbart die DE-PS 1 094 332 ein in der Länge variierbares Gehäuse für elektrische Schaltgeräte, bei dem zwischen zwei Rahmen Spannbolzen angeordnet sind, welche kurze Blöcke mit Ausnehmungen aneinandergereiht tragen und in deren Ausnehmungen jeweils Seitenwände eingesteckt gehalten und zwischen den Blöcken an den Spannbolzen Zwischenwände einsetzbar sind.

Durch Wahl der Anzahl an Blöcken können unterschiedliche Wandlängen eingesetzt werden zur Bildung verschieden langer Gehäuse. Hierbei sind die Seitenwände von Platten gebildet, welche lose aneinanderstoßen und in den Ausnehmungen der Blöcke und durch die Spannbolzen gehalten sind. Die auf jedem Spannbolzen aneinandergereihten Blöcke bilden jeweils eine Längsecke.

Ausgehend von dem Gehäuse nach der CH-PS 677 855 liegt der Erfindung die Aufgabe zugrunde, ein Gehäuse zu schaffen, dessen Wandungen in einfacher, kostengünstiger und montagemäßig bequemer Weise in der Gehäusetiefe variabel gestaltet und durch günstige Eckverbinder stabil zusammengehalten sind.

Diese Aufgabe wird erfindungsgemäß durch die kennzeichnenden Merkmale des Patentanspruches 1 gelöst.

Die sich an diesen Patentanspruch 1 anschließenden Unteransprüche beinhalten Gestaltungsmerkmale, welche vorteilhafte und förderliche Weiterbildungen der Aufgabenlösung darstellen.

Das erfindungsgemäße Steuergehäuse weist Wandungen auf, die aus durch Steck-Rastverbindungen zusammengehaltenen Profilen bestehen und deren Wandungen an den Stirnseiten durch über die gesamte Gehäusetiefe durchgehende Längsecken mittels Schrauben zusammengehalten sind.

Als Profile für die Wandungsbildung sind zwei Außenprofile und eine oder mehrere Mittelprofile vorgesehen, an denen die Steck-Verbindungsmittel angeformt sind.

Durch Zusammensetzen zweier Außenprofile, welche dann durch ihre Steck-Rastmittel zusammengeclipst werden, entsteht die kleinste Gehäuseausführung, d.h. ein Steuergehäuse mit kleinster Tiefe.

Durch das Zusammensetzen zweier Außenprofile und eines oder mehrerer dazwischen angeordneter Mittelprofile, wobei diese Profile ebenfalls wieder durch die Steck-Rastverbindung zusammengeclipst werden, können verschiedene Gehäusetiefen erreicht werden.

Alle zusammengeclipsten Profile werden dann durch die vier Längsecken und durch im Bereich der Außenprofile in Schraubkanäle einfassende Schrauben zusammengehalten.

In die Außenprofile mit Längsecken lassen sich dann wahlweise eine Klarsichtscheibe, eine Frontplatte oder eine Rückwand einsetzen, die durch Klemmstücke an den Außenprofilen gehalten und durch einen die Klemmstücke überdeckenden Abdeckrahmen randseitig umfaßt sind.

In den Längsecken sind für die Schrauben die Durchgangslöcher herstellungsmäßig ausgeformt und weiterhin weisen die Längsecken in ihren Längenendbereichen herstellungsgemäßig gebildete, vertiefte Aufnahmen für Eckwinkel, Scharniere und mit diesen Scharnieren zusammenwirkende Sicherungszungen auf.
Es können somit zwei oder mehrere Gehäuse durch die Eckverbinder, welche in die Längsecken eingesetzt und durch Schrauben festgelegt werden, starr miteinander verbunden werden, oder aber durch den Einsatz von Scharnieren schwenkbar aneinander gereiht werden, wobei den Scharnieren im Gehäuse gegenüberliegend die Sicherungszungen zugeordnet sind, welche die zusammengeschwenkten Gehäuse in ihrer Lage fixieren, d.h. gegen Absenken sichern und somit das Gehäusegewicht auffangen.

An dem oder den Gehäusen lassen sich eine oder mehrere Türen fest, d.h. über die Eckverbinder, oder schwenkbar, d.h. über die Scharniere, mit gegenüberliegenden Sicherungszungen anbringen, wobei jede Tür wiederum aus vier Türprofilen und vier diese mittels Schrauben verbindenden Eckstücken besteht und somit ein Türrahmen gebildet wurde.

In dieser Tür wird ebenfalls wahlweise eine Klarsichtscheibe, eine Frontplatte oder eine Rückwand eingesetzt, durch Klemmstücke gehalten und randseitig durch einen Abdeckrahmen abgedeckt.

Durch das Gehäuse und die Tür ist erfindungsgemäß eine variable Verbindung von Gehäuse/Gehäuse sowie Gehäuse/Tür in schwenkbarer oder fester Verbindung ermöglicht worden und die hierfür vorgesehenen Verbindungsmittel werden in den Längsecken bzw. Eckstücken herstellungsseitig vorgesehenen Aufnahmen leicht untergebracht und von Eckklappen nach außen unsichtbar abgedeckt. Diese Eckklappen bestehen aus Kunststoffwinkeln, welche in Nuten und Aussparungen der Längsecken bzw. der Eckstücke einsetzbar sind und welche entsprechend dem Einsatz von Scharnieren abtrennbare Klappenelemente zeigen.
Gehäuse und Türprofile mit Steck-Rastmitteln, Aufnahmen für Scheibe, Front- oder Rückwand und Abdeckrahmen sowie Klemmstücken und der Längsecken bzw. Eckstücke mit den Aufnahmen für die Verbindungsmittel (Schrauben, Eckverbinder, Scharnier) und die Eckklappen lösen die weitere Aufgabe einer einfachen, kostengünstigen und montagemäßig bequemen Gehäuse/Tür-Kombination in verschiedener Ausführung.

Anhand der Zeichnungen wird nachfolgend ein Ausführungsbeispiel der Erfindung näher erläutert:
Es zeigt:
- Fig. 1: eine perspektivische Explosionsdarstellung einer Steuergehäuse-Variation aus Tür mit Klarsichtscheibe, Tür mit Frontplatte, zwei Grundgehäusen und einer Klarsichtscheibe oder Frontplatte (Rückwand) mit Abdeckrahmen,
- Fig. 2: einen Querschnitt durch zwei spiegelbildlich angeordnete Türprofile,
- Fig. 3: einen Querschnitt durch zwei miteinander verbundene und die kleinste Grundgehäuseausführung bildende Außenprofile,
- Fig. 4: einen Querschnitt durch zwei Außenprofile und ein dazwischen angeordnetes Mittelprofil, welche zusammen die nächst größere Grundgehäuseausführung bilden,
- Fig. 5: einen Querschnitt durch zwei Außenprofile und zwei dazwischen angeordnete Mittelprofile, die zusammen eine weitere, größere Grundgehäuseausführung ergeben,
- Fig. 5a: einen Querschnitt der Steck-Rastverbindung der Außenprofile und/oder Mittelprofile in vergrößerter Darstellung und im gelösten Zustand,
- Fig. 6 und 7: eine perspektivische Außen- und Innenansicht einer die Außen- und Mittelprofile verbindenden Längsecke,
- Fig. 8 bis 10: eine perspektivische Außen-, Seiten- und Innenansicht eines die Türprofile verbindenden Eckstückes,,
- Fig. 11: einen Schnitt in Steuergehäusetiefe mit zwei frontseitigen Türen, zwei Grundgehäusen und einer weiteren rückseitigen Tür,
- Fig. 12: einen Querschnitt durch ein Türprofil mit durch Klemmstücke gehaltener und durch einen Abdeckrahmen randseitig abgedeckter Scheibe oder Frontwand oder Rückwand gemäß Ausschnitt "A" in Fig. 11,
- Fig. 13: eine Vorderansicht einer Tür oder eines Grundgehäuses mit umlaufenden Abdeckrahmen und Klemmstücken gemäß Fig. 12,
- Fig. 14: einen Querschnitt durch die Eckverbindung zweier Tür- oder Gehäuseprofile mittels Längsecke oder Eckstück und Schrauben und eingesetzten Eckklappen,
- Fig. 15: eine perspektivische Teildarstellung einer Längsecke mit angeschraubtem Eckverbinder und abgenommener, die Schraubverbindungsstellen überdeckenden Eckklappe,
- Fig. 16: eine perspektive Darstellung der Eckklappe,
- Fig. 17: einen Querschnitt durch den Verbindungsbereich von Tür/Tür oder Tür/Grundgehäuse oder Grundgehäuse/Grundgehäuse durch den Eckverbinder,
- Fig. 18: einen Schnitt durch den Verbindungsbereich entsprechend Fig. 17 jedoch mit Scharnier und gegenüberliegender Sicherungszunge,
- Fig. 19 und 20: einen Schnitt und eine Seitenansicht eines Hakenverschlusses für Tür/Tür bzw. Klarsichthaube/Tür mit Knebelgriff,
- Fig. 21 and 22: einen Schnitt und eine Seitenansicht eines Hakenverschlusses für Grundgehäuse/Grundgehäuse bzw. Grundgehäuse/Tür mit Schließdorn und Kappe

Das Steuergehäuse für die Aufnahme elektrischer, elektronischer und mechanischer Bauteile setzt sich aus mindestens einem, vier Wandungen (2) und diese zusammenhaltenden Eckverbinder (3) aufweisenden Grundgehäuse (1) und mindestens einer am Grundgehäuse (1) fest oder schwenkbar angebrachten Tür (Rahmen) (4) zusammen.

Jede Wandung (2) des Grundgehäuses (1) ist aus mindestens zwei mit ihren Längsrändern durch Steck-Rastverbindung (5,6) zusammengehaltenen Profilen (7,8,9) gebildet, welche durch vier jeweils zwischen zwei rechtwinklig zueinanderstehenden Stirnenden der Profile (7,8,9) anliegende Längsecken (3) und mehreren die Längsecken (3) durchfassende und in Schraubkanäle (10) der Profile (7,8) eingreifende Schrauben (11) verbunden sind.

Das Grundgehäuse (1) läßt sich zur Bildung der Gehäusewandungen (2) und variabler Gehäusetiefen aus zwei Außenprofilen (7,8) und einem oder mehreren dazwischen angeordneten Mittelprofilen (9) zusammensetzen, welche mit ihrer Länge in Gehäusehöhe und Gehäusebreite verlaufen und wobei die beiden Außenprofile (7,8) miteinander bzw. die Mittelprofile (9) miteinander und mit den Außenprofilen (7,8) durch Steck-Rastverbindung (5,6) verbunden sind und die Außenprofile (7,8) jeweils einen Schraubkanal (10) für die Verbindung der Gehäusewandungen (2) mit den Längsecken (3) durch die Schrauben (11) aufweisen.

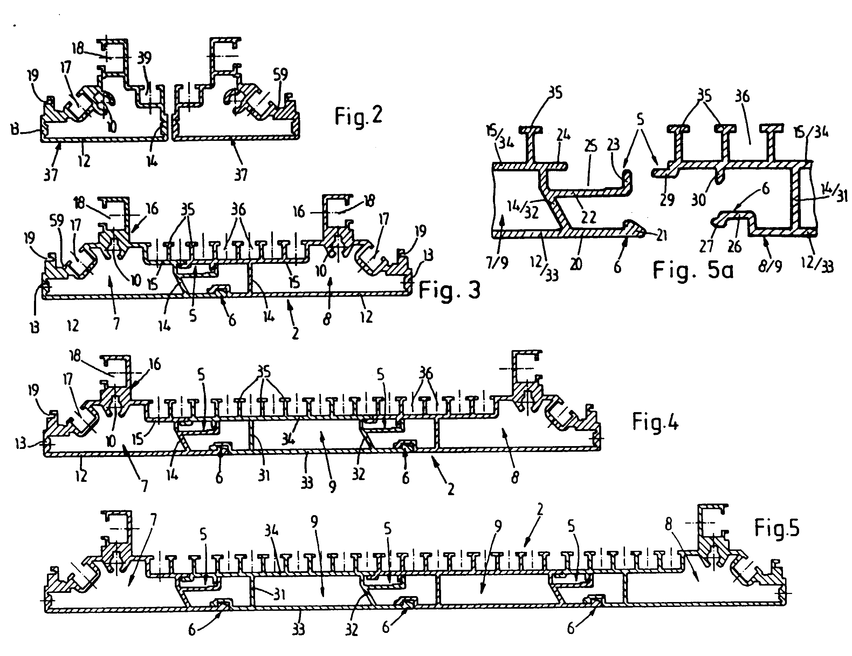

Aus Fig. 3 ist die Verbindung zweier Außenprofile (7,8) zur kleinsten festen Grundgehäuseausführung ersichtlich; durch das Zwischensetzen eines Mittelprofiles (9) gemäß Fig. 4 wird die nächst größere Grundgehäuseausführung erreicht und durch die Steck-Rastverbindung (5,6) zweier oder mehrerer Mittelprofile (9) miteinander und mit zwei Außenprofilen (7,8) können weitere größere Grundgehäuseausführungen wahlweise geschaffen werden (Fig. 5).

Das Außenprofil (7,8) ist als Hohlprofil mit einer in sich ebenen Außenwand (12), zwei davon abstehenden Längsrändern (13,14), einen sich auf dem inneren Längsrand (14) abstützenden, parallel zu Außenwand verlaufenden Innenwandabschnitt (15) und einem sich von dem äußeren Längsrand (13) und dem Innenwandabschnitt (15) abstehenden Profilabschnitt (16) gebildet. Dieser Profilabschnitt (16) zeigt eine im Querabschnitt hinterschnitttene, schräg zum senkrechten äußeren Längsrand (13) geöffnete Montagenut (17), einen im Abstand neben dieser Montagenut (17) angeordneten, im Querschnitt hinterschnittenen und zum Hohlraum des Außenprofile (7,8) offenen Schraubkanal (10) ein vom Schraubkanal (10) zum Gehäuseinnenraum abstehendes in Richtung äußeren Längsrand (13) offenes U-Profil (18) und eine gegenüber dem äußeren Längsrand (13) zurückversetzte und vor der Montagenut (17) liegende, nach außen offene Nut (19).

Das eine Außenprofil (7) hat an seinem inneren, vorzugsweise schrägstehenden Längsrand (14) eine äußere, in Verlängerung des Außenwand (12) verlaufende Rastleiste (20) mit freiendseitiger Rastnase (21) und eine innere im parallelen Abstand zum Innenwandabschnitt (15) und parallel zur äußeren Rastleiste (20) verlaufende Halteleiste (22) mit freiendseitigem Haltewinkel (23), die mit einem sich in Verlängerung des Innenwandabschnittes (15) verlaufenden und über den inneren Längsrand (14) hinausragenden Steg (24) eine Einstecknut (25) bildet.

Das zweite Außenprofil (8) besitzt an seinen inneren, vorzugsweise senkrecht stehenden Längsrand (14) eine äußere, in Verlängerung der Außenwand (12) verlaufende, hakenartige, mit der Rastleiste (20,21) des ersten Außenprofiles (7) verrastende Rastleiste (26) mit Rastnase (27) und eine innere, in Verlängerung des Innenwandabschnittes (15) über die äußere Rastleiste (26) hinaus verlaufende Einsetzleiste (28) mit freiendseitigem, abgestuften Haltewinkel (29) und einem im Abstand vor dem Haltewinkel (29) senkrecht in Richtung Rastleiste (26) von der Einsetzleiste (28) abstehenden Widerlagersteg (30); für die Steck-Rastverbindung werden der Haltewinkel (29) und Widerlagersteg (30) in die Einstecknut (25) des ersten Außenprofiles (7) eingesetzt und dabei greift der Haltewinkel (29) unter den Steg (24) und der Widerlagersteg (30) liegt vor dem Haltewinkel (23) und die Rastleiste (26) ist mit ihrer Rastnase (27) hinter der Rastnase (21) der Rastleiste (20) verhakt (verclipst (Fig. 3 bis 5).

Das Mittelprofil (9) ist von einem hohlen Plattenelement mit in sich ebener, durch einen senkrechten und einen schrägstehenden Längsrand (31,32) im parallelen Abstand zueinander gehaltener Außen- und Innenwand (33,34) gebildet und an seinen beiden Längsrändern (31,32) sind die für die Verbindung von benachbarten Mittelprofilen (9) und mit den Außenprofilen (7,8) die gleichen Steck-Rastmittel (20,21,23,24,25/26,27,28,29,30) angeformt wie bei den Außenprofilen (7,8). Aus Fig. 5 a sind diese Steck-Rastmittel (20 bis 30) deutlich zu erkennen.

Auf dem Innenwandabschnitt (15) des ersten Außenprofiles (7) ist ein, auf dem Innenwandabschnitt (15) des zweiten Außenprofiles (8) und auf der Innenwand (34) jedes Mittelprofiles (9) sind mehrere, im Querschnitt vorzugsweise T-förmige Profilleisten (35) angeformt, welche im Querschnitt hinterschnittene Montagenuten (36) für die im Gehäuse unterzubringenden Bauteile bilden.

Die Tür (4) setzt sich aus vier Türprofilen (37) und vier jeweils zwischen zwei rechtwinklig zueinanderstehenden Stirnenden der Türprofile (37) anliegenden Eckstücken (38) als Eckverbindern zusammen; mehrere, die Eckstücke (38) durchfassende und in einen Schraubkanal (10) jedes Türprofiles (37) eingreifende Schrauben (11) halten die Türprofile (37) und Eckstücke (38) zu einem Rahmen zusammen.

Das Türprofil (37) ist als im Querschnitt trapezartiges Hohlprofil ausgeführt und entspricht im Querschnitt und dessen Ausbildung im wesentlichen einem Außenprofil (7,8), hat lediglich keine Steck-Rastverbindungsmittel (5,6) und keine Profilleisten (35) mit Montagenuten (36). Nachfolgend wird kurz nochmals die Querschnittsausführung des Türprofiles (37) beschrieben, wobei für Profilteile, die auch beim Außenprofil (7,8) vorhanden sind, die gleichen Bezugszahlen verwendet werden.

Dieses Türprofil (37) weist eine in sich ebene Außenwand (12), zwei sich darauf abhebende und senkrecht zur Außenwand (12) stehende Längsränder (13,14) und einen in sich darauf abhebenden Profilabschnitt (16) auf, der vom äußeren Längsrand (13) aus zur Profilmitte schräg von der Außenwand (12) weg eine erste längsrandseitige Nut (19), eine im Querschnitt hinterschnittene Montagenut (17), einen zum Profil-Hohlraum hin offenen Schraubkanal (10) und ein darüberliegendes, nach außen offenes U-Profil (18) und neben dem inneren Längsrand (14) ein zweites, zur Türprofil-Innenseite hin offenes U-Profil (39) zeigt.

Das Türprofil (37), die beiden Außenprofile (7,8) und das Mittelprofil (9) sind als einstückige Strangprofile aus Aluminium hergestellt.

Die Längsecke (3) ist von einem sich über die gesamte Tiefe des Gehäuses -jeder aus den Profilen (7,8,9) gebildeten Wandung (2)- erstreckenden Winkelprofil gebildet, dessen rechtwinklig zueinanderstehenden, über die Länge der Längsecke (3) verlaufenden, freien Schenkelflächen der beiden Winkelschenkel (40) in sich ebenen Anlageflächen (40a) für die Profilstirnflächen bilden und das im Abstand zu seinen beiden Längenenden im Innenwinkel -Innenseiten der Winkelschenkel (40)- je einen Anlagewinkel (41) für den Schraubkanal (10) und das daran zum Gehäuse-Innenraum anschließende U-Profil (18) der Außenprofile (7,8) zeigt, wobei in jedem der beiden Anlagewinkel (41) zwei rechtwinklig zueinander stehende Durchstecklöcher (42) für die in die Schraubkanäle (10) der Außenprofile (7,8) eingreifenden Schrauben (11) und Gewindebohrungen (4a) vorgesehen sind.

In beiden Längenenden der Winkelschenkel (40) der Längsachse (3) ist in beiden Winkelschenkel-Außenseiten je eine zu den Längenenden hin offene Vertiefung (43) ausgespart, in der wahlweise ein Eckverbinder (44) in Form eines Verbindungssteines zur Verbindung zweier aneinandergereihter Gehäuse (1) oder eines Gehäuses (1) und einer Tür (4) oder ein Scharnier(45) und eine dem Scharnier (45) im Gehäuse (2) gegenüberliegenden Sicherungszunge (46)als Auffang- oder Aufnahmelappen mittels in die Gewindebohrungen (49) eingreifender Schrauben (47) festlegbar ist.

Das Eckstück (38) der Tür (4) ist als Eckwinkel mit im Querschnitt T-förmigen Winkelschenkeln (48) ausgeführt, dessen freiendseitige T-Flächen in sich ebene Anlageflächen (48a) für den Schraubkanal (10) und das sich daran in Richtung Tür-Innenraum anschließende U-Profil (18) des Türprofiles (37) bilden; in den Winkelschenkeln (48) sind außenseitig ebenfalls Vertiefungen (43) für das Einsetzen des Scharnieres (45) und der Sicherungszunge (46) oder eines Eckverbinders (44) ausgeformt und in Schenkel-Längsrichtung verlaufende, rechtwinklig zueinander stehende Durchgangslöcher (42) für die Schrauben (11) zur Eckstück-Türprofil-Verbindung Gewindebohrungen (49) für die Befestigung des Scharniers (45), der Sicherungszunge (46) und des Eckverbinders (44) ausgenommen.

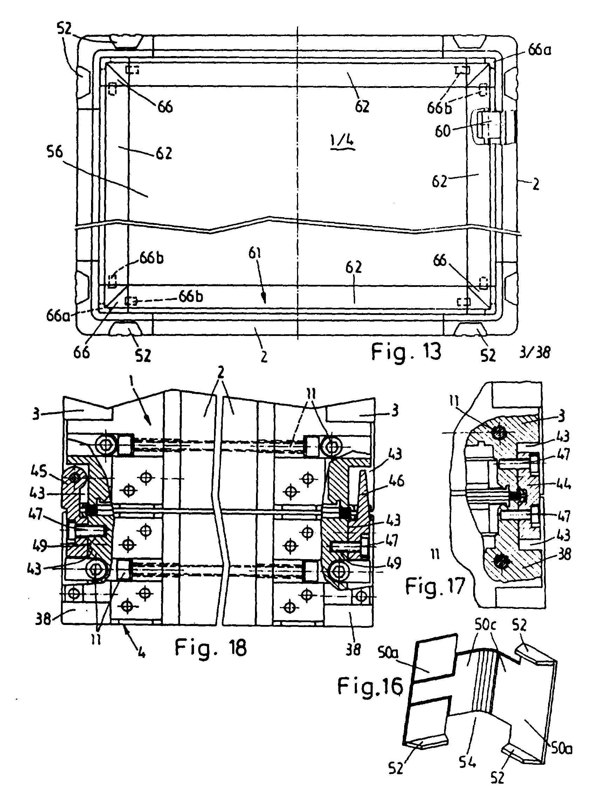

Die Längsecke (3) wird in ihren beiden Längenendbereichen und das Eckstück (38) außenseitig von einer winkelförmigen Eckklappe (50) überdeckt, welche in Vertiefungen (51) der Längsecke (3) und des Eckstückes (38) außen bündig liegend eingesetzt ist, mit randseitigen Abwinklungen (52) in Nuten (53) und/oder in die Vertiefungen (43) der Längsecke (3) und des Eckstückes (38) eingreift und entsprechend dem Einsatz von Scharnier (45) in ihren Winkelschenkeln (50a) und/oder Abwinklungen (52) abtrennbar ist (in Fig. 15 ist ein abgetrenntes Schenkel-Abwinklungsteil (50b) und in Fig. 16 ein Winkelschenkel (50a) mit abgetrennter Abwinklung (52) gezeigt.

Diese Eckklappen (50) sind einstückig aus Kunststoff hergestellt, werden in der Herstellungsform an beiden Seiten beider Winkelschenkel (50a) mit je einer lappenförmigen Abwinklung (52) ausgestaltet und zwischen diesen vier Abwinklungen (52) ist die Breite der Schenkel (50a) durch beidseitige Aussparungen (54) verringert, so daß die schmalen Schenkelbereiche (50c) in die Vertiefungen (51) der Längsecke (3) und des Eckstückes (38) hineinpassen, dann die breiteren Schenkelbereiche (50a) in der Vertiefung (51) in Richtung Anlageflächen (48a) die gesamte Breite des Eckstückes (38) bzw. den Endbereich der Längsecke (3) überdecken und mit ihren Abwinklungen (52) in die Nuten (53) eingesteckt sind sowie mit den Abwinklungen (52) in die freiendseitigen Stirnenden der Vertiefungen (43) der Längsecke (3) bzw. in die Stirnenden der Vertiefungen (43) des Eckstückes (38) einfassen, wodurch der gesamte ausgesparte Außenbereich der Längsecke (3) und des Eckstückes (38) geschlossen ist. Wenn ein Scharnier (45) eingesetzt wird, dann wird für das Außengelenk des Scharnieres (45) zur Freigabe für die Verschwenkdurchführung und für die dem Scharnier (45) gegenüberliegende Sicherungszunge (43) zum Einlegen in die Vertiefung (43) der benachbarten Tür (4) oder des benachbarten Grundgehäuses (1) das entsprechende Klappenelement (50b) von der Eckklappe (50) abgetrennt (Fig. 15).

Die Längsecke (3) und das Eckstück (38) sind jeweils einstückig als Gußteil aus Aluminium hergestellt. Längsecke (3), Eckstück (38) und Eckklappe (50) haben im äußeren Scheitelpunkt ihres Winkels jeweils eine abgerundete Form -runde Außenecke (55) in Fig. 13-.

Beim Einsatz von Scharnieren (45) wird in den dem Scharnier (45) gegenüberliegenden Gehäuse- bzw. Türbereich stets eine Sicherungszunge (46) eingesetzt, die sich in die Vertiefung (43) einlegt und somit die Tür (4) bzw. das Gehäuse (1) unterstützt, so daß ein Absenken (Hängen) des beweglichen Bauteiles (4/1) gegenüber dem feststehenden Bauteil (4/1) vermieden wird.

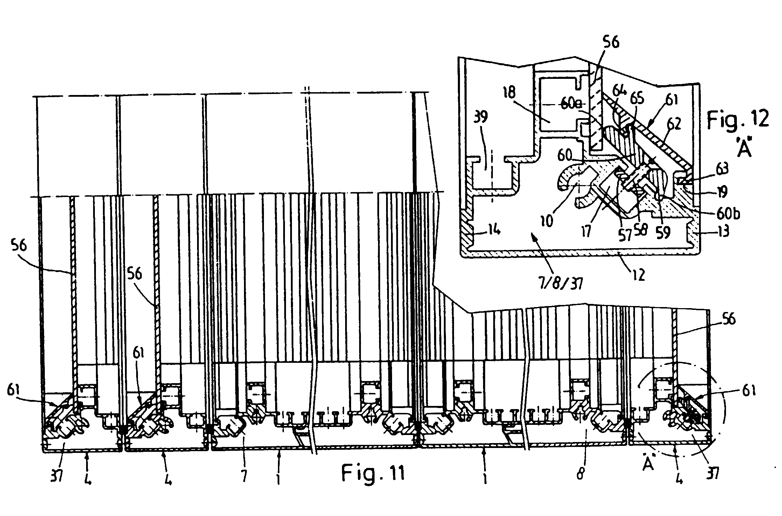

In der Tür (4) und dem Grundgehäuse (1) lassen sich wahlweise eine Klarsichtscheibe (56), Frontplatte (56) oder Rückwand (56) einsetzen; wie Fig. 11 und 12 zeigen, liegt dann dieses plattenförmige Bauteil (56) an dem U-Profil (18) des Außenprofiles (7,8) oder des Türprofiles (37) und an einer Seite des Anlagewinkels (41) vom Eckstück (38) bzw. Längsecke (3) an dem gebildeten umlaufenden Tür- oder Gehäuserahmen an und wird durch mehrere auf dem Umfang des Bauteiles (56) angeordnete Klemmstücke (60) gehalten.

In die Montagenuten (17) der Profile (7,8/37) ist für jedes Klemmstück (60) mindestens eine Mutter (57) eingeschoben und eine das Klemmstück (60) durchfassende und in die Mutter (57) eingeschraubte Schraube (58) drückt gegen das Bauteil (56). Dieses Klemmstück (60) ist als profiliertes Plattenteil ausgeführt, welches mit einer Plattenkante (60a) an der Scheibe, Frontplatte oder Rückwand (56) anliegt und mit einer zweiten, wulstartigen Plattenkante (60b) in einer Lagerrinne (59) vom Außen- oder Türprofil (7,8/37) lagefixiert eingreift.

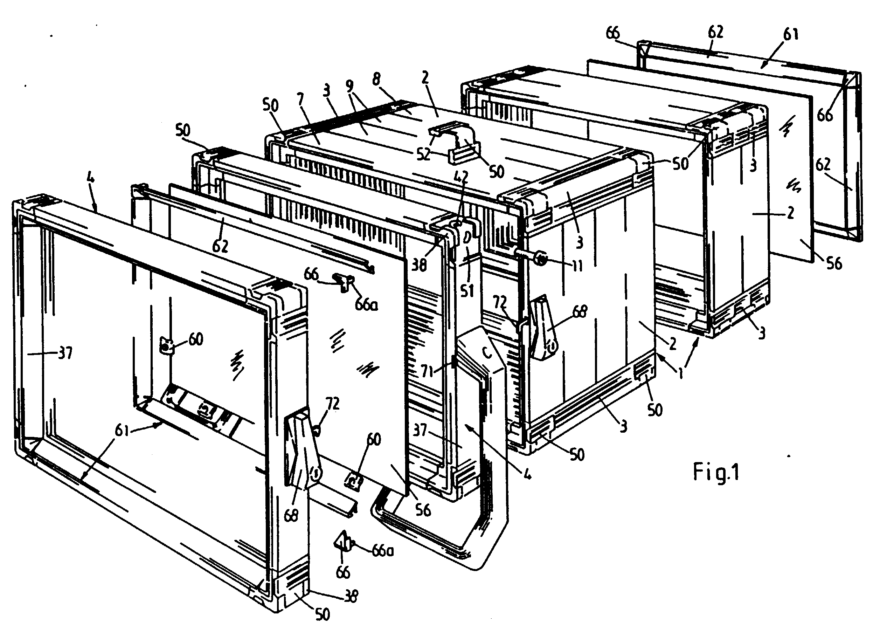

Die Klarsichtscheibe (56), die Frontplatte (56) oder die Rückwand (56) als front- oder rückseitiges Bautell werden umlaufend von einem Abdeckrahmen (61) -Fig. 1- im Bereich der Klemmstücke (60) abgedeckt. Dieser Abdeckrahmen (61) besteht aus Deckprofilen (62) aus Kunststoff, welche schrägliegend mit einem Haltehaken (63) in die Nut (19) vom Außen- bzw. Türprofil (7,8/37) und in eine Nut (19) der Längsecke (3) bzw. des Eckstückes (38) eingreifen und mit einer Rastnase (64) hinter eine Gegennase (65) der Klemmstücke (60) verrasten.

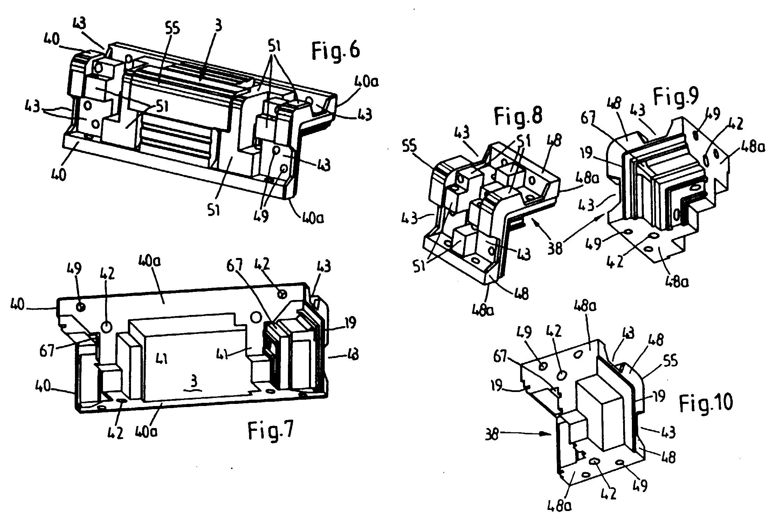

In den Eckstößen der Deckprofile (62) werden Abdeckecken (66) aus Kunststoff eingesetzt, die mit einem Steckwinkel (66a) in je eine im Innenwinkel-Scheitelpunkt ausgesparte Nut (67) von Eckstück (38) und Längsecke (3) -Fig. 7 und 9-eingesteckt sind und mit den Deckprofilen (62) bündig zusammenstoßen und mit angeformten Lappen (66b) unter die Deckprofile (62) greifen (Fig. 1 und 13).

Wie Fig. 1 zeigt, kann das Steuergehäuse beispielsweise von vorn nach hinten aus einer Tür (4) mit Klarsichtscheibe (56), einer weiteren Tür (4) mit Frontplatte (56), zwei Grundgehäusen (1) gebildet sein, wobei die Rückseite des hinteren Grundgehäuses (1) durch eine Klarsichtscheibe (56), Frontplatte (56) oder Rückwand (56) geschlossen und dann, wie auch die beiden vorderen Türen (4) und das vordere Gehäuse (1) randseitig von einem Abdeckrahmen (61) umfaßt ist.

Jede Tür (4) ist jeweils durch Scharniere (45) mit einer zweiten Tür (4) oder mit einem Grundgehäuse (1) verbunden. Die Tür (4) kann auch über Scharniere (45) schwenkbar oder über Eckverbinder (44) fest mit einem Grundgehäuse (1) verbunden sein. Desweiteren lassen sich zwei oder mehrere Grundgehäuse (1) durch Scharniere (45) schwenkbar oder durch Eckverbinder (44) fest miteinander verbinden.

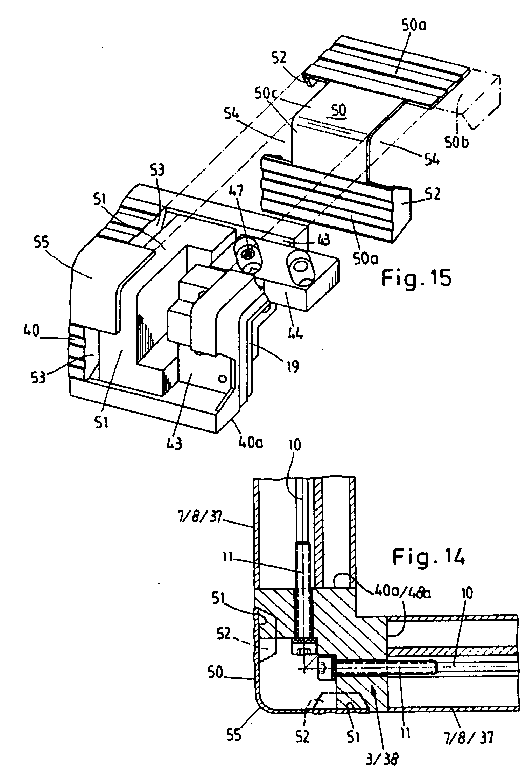

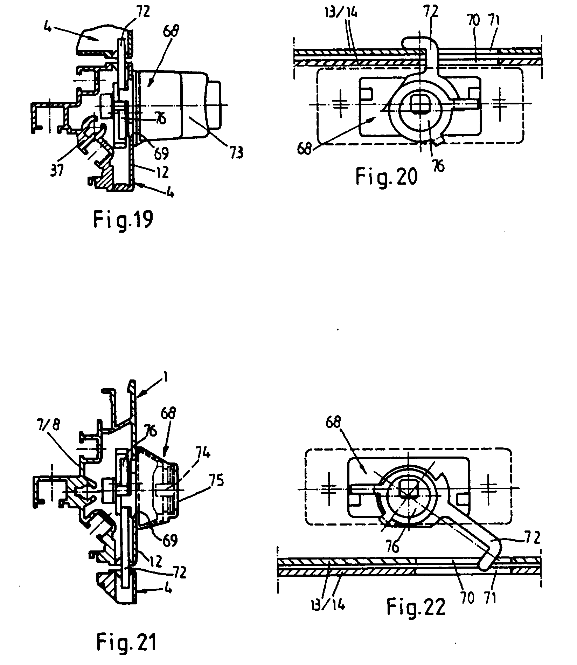

Bei der schwenkbaren Verbindung von Tür (4)/Tür (4) oder Tür (4)/Grundgehäuse (1) oder Grundgehäuse (1)/Grundgehäuse (1) ist jeweils ein Verschluß (68) eingesetzt. In bevorzugter Weise ist dieser Verschluß (68) von einem Hakenverschluß gebildet, der in eine erstellte Aussparung (69) der Außenwand (12) des Türprofiles (37) bzw. des Außenprofiles (7,8) eingesetzt ist und der einen aus einer Aussparung (70) in dem Längsrand (13) von Tür- oder Außenprofil (7,8,9) herausbewegbaren und in eine entsprechende Aussparung (71) des Längsrandes (13) der benachbarten Tür (4) oder Grundgehäuse (1) eingreifenden Verschlußhaken (72) aufweist, der von einem Knebelgriff (73) oder einem Schließdorn (74) mit Abdeckkappe (75) um einen Exzenter (76) verschwenkt wird und dabei die benachbarten Bauteile (4 und 1) mit ihren Profil-Längsrändern (13) zusammenzieht (Fig. 1, 19 bis 22).

## Patentansprüche

1. Steuergehäuse für die Aufnahme elektrischer, elektronischer und mechanischer Bauteile, welches aus mindestens einem Grundgehäuse, das vier Wandungen und diese zusammenhaltende Eckverbinder aufweist, und mindestens einer am Grundgehäuse fest oder schwenkbar angebrachten Tür (Rahmen) besteht, dadurch gekennzeichnet, daß jede Wandung (2) des Grundgehäuses (1) aus mindestens zwei mit ihren Längsrändern durch Steck-Rastverbindung (5,6) zusammengehaltenen Profilen (7,8,9) gebildet ist, welche durch vier jeweils zwischen zwei rechtwinklig zueinanderstehenden Stirnenden der Profile (7,8,9) anliegende Längsecken (3) und mehreren die Längsecken (3) durchfassende und in Schraubkanäle (10) der Profile (7,8,9) eingreifende Schrauben (11) verbunden sind.

2. Steuergehäuse nach Anspruch 1, dadurch gekennzeichnet, daß das Grundgehäuse (1) zur Bildung der Gehäusewandungen (2) und variablen Gehäusetiefen aus zwei Außenprofilen (7,8) oder zwei Außenprofilen (7,8) und einem oder mehreren dazwischen angeordneten Mittelprofilen (9) besteht, welche mit ihrer Länge in Gehäusehöhe und Gehäusebreite verlaufen und wobei die beiden Außenprofile (7,8) miteinander bzw. die Mittelprofile (9) miteinander und mit den Außenprofilen (7,8) durch Steck-Rastverbindung (5,6) verbunden sind, und die Außenprofile (7,8) jeweils einen Schraubkanal (10) für die Verbindung der Gehäusewandungen (2) mit den Längsecken (3) durch die Schrauben (11) aufweisen.

3. Steuergehäuse nach Anspruch 1 oder 2, dadurch gekennzeichnet, daß das Außenprofil (7,8) als Hohlprofil mit einer in sich ebenen Außenwand (12), zwei davon abstehenden Längsrändern (13,14), einen sich auf dem inneren Längsrand abstützenden, parallel zur Außenwand (12) verlaufenden Innenwandabschnitt (15) und einen sich von dem äußeren Längsrand (13) und dem Innenwandabschnitt (15) abhebenden Profilabschnitt (16) gebildet ist und dabei der Profilabschnitt (16) eine im Querschnitt hinterschnittene, schräg nach außen stehende und zum senkrechten äußeren Längsrand (13) geöffnete Montagenut (17) einen im Abstand neben der Montagenut (17) angeordneten, im Querschnitt hinterschnittenen und zum Hohlraum des Außenprofile (7,8) offenen Schraubkanal (10), ein vom Schraubkanal (10) zum Gehäuseinnenraum abstehendes in Richtung äußeren Längsrand {13) offenes U-Profil (18) und eine gegenüber dem äußeren Längsrand (13) zurückversetzte und vor der Montagenut (17) liegende, nach außen offene Nut (19) aufweist.

4. Steuergehäuse nach einem der Ansprüche 1 bis 3, dadurch gekennzeichnet, daß das eine Außenprofil (7) an seinem inneren, vorzugsweise schrägstehenden Längsrand (14) eine äußere, in Verlängerung der Außenwand (12) verlaufende Rastleiste (20) mit freiendseitiger Rastnase (21) und eine innere im parallelen Abstand zum Innenwandabschnitt (15) und parallel zur äußeren Rastleiste (20) verlaufende Halteleiste (22) mit freiendseitigem Haltewinkel (23) hat, die mit einem sich in Verlängerung des Innenwandabschnittes (15) verlaufenden und über den inneren Längsrand (14) hinausragenden Steg (24) eine Einstecknut (25) bildet, und daß das zweite Außenprofil (8) an seinem inneren, vorzugsweise senkrecht stehenden Längsrand (14) eine äußere, in Verlängerung der Außenwand (12) verlaufende, hakenartige Rastleiste (26) mit Rastnase (27) und eine innere in Verlängerung des Innenwandabschnittes (15) über die äußere Rastleiste (26) hinaus verlaufende Einsetzleiste (28) mit freiendseitigem, abgestuften Haltewinkel (29) und einem im Abstand vor dem Haltewinkel (29) senkrecht in Richtung Rastleiste (26) von der Einsetzleiste (29) abstehenden Widerlagersteg (30) zeigt, wobei für die Steck-Rastverbindung der Haltewinkel (29) und Widerlagersteg (30) in die Einstecknut (25) des ersten Außenprofiles (7) eingreifen, dabei der Haltewinkel (29) unter den Steg (24) faßt und der Widerlagersteg (30) vor dem Haltewinkel (23) liegt und die Rastleiste (26) mit ihrer Rastnase (27) hinter der Rastnase (21) der zweiten Rastleiste (20) verhakt ist.

5. Steuergehäuse nach einem der Ansprüche 1 bis 4, dadurch gekennzeichnet, daß das Mittelprofil (9) von einem hohlen Plattenelement mit in sich ebener, durch einen senkrechten und einen schrägstehenden Längsrand (31,32) im parallelen Abstand zueinander gehaltener Außen- und Innenwand (33,34) gebildet ist und an seinen beiden Längsrändern (31,32) die für die Verbindung von benachbarten Mittelprofilen (9) und mit den Außenprofilen (7,8) vorgesehene Steck-Rastmittel (20 bis 30) zeigt.

6. Steuergehäuse nach einem der Ansprüche 1 bis 5, dadurch gekennzeichnet, daß auf dem Innenwandabschnitt (15) des ersten Außenprofiles (7) ein, auf dem Innenwandabschnitt (15) des zweiten Außenprofiles (8) und der Innenwand (34) des Mittelprofiles (9) mehrere, im Querschnitt vorzugsweise T-förmige Profilleisten (35) angeformt sind, welche im Querschnitt hinterschnittene Montagenuten (36) für die im Gehäuse unterzubringenden Bauteile bilden.

7. Steuergehäuse nach einem der Ansprüche 1 bis 6, dadurch gekennzeichnet, daß die Tür (4) einen aus vier Türprofilen (37) und vier jeweils zwischen zwei rechtwinklig zueinanderstehenden Stirnenden der Türprofile (37) anliegenden Eckstücken (38) und mehreren die Eckstücke (38) durchfassenden und in einen Schraubkanal (10) jedes Türprofiles (37) eingreifenden Schrauben (11) gebildeten Rahmen hat.

8. Steuergehäuse nach einem der Ansprüche 1 bis 7, dadurch gekennzeichnet, daß das Türprofil (37) als im Querschnitt trapezartiges Hohlprofil mit einer in sich ebenen Außenwand (12) zwei sich darauf abhebenden und senkrecht zur Außenwand (12) stehenden Längsrändern (13,14) und einem sich darauf abhebenden Profilabschnitt (16) gebildet ist, wobei der Profilabschnitt (16) vom äußeren Längsrand (13) zur Profilmitte hin schräg von der Außenwand (13) weg eine längsrandseitige Nut (19), eine im Querschnitt hinterschnittene Montagenut (17), einen zum Profil-Hohlraum hin offenen Schraubkanal (10) und ein darüberliegendes, nach außen offenes U-Profil (18) und neben dem inneren Längsrand (14) ein zweites, zur Türprofil-Innenseite hin offenes U-Profil (39) aufweist.

9. Steuergehäuse nach einem der Ansprüche 1 bis 8, dadurch gekennzeichnet, daß das Türprofil (37), die beiden Außenprofile (7,8) und das Mittelprofil (9) als einstückige Strangprofile aus Aluminium hergestellt sind.

10. Steuergehäuse nach einem der Ansprüche 1 bis 9, dadurch gekennzeichnet, daß die Längsecke (3) von einem sich über die gesamte Tiefe des Gehäuses -jeder aus den Profilen (7,8,9) gebildeten Wandung (2)- erstreckenden Winkelprofil gebildet ist, dessen rechtwinklig zueinanderstehende, freien Schenkelflächen der beiden Winkelschenkel (40) in sich ebene Anlageflächen (40a) für die Profil-Stirnflächen bilden und das im Abstand zu seinen beiden Längenenden im Innenwinkel (Innenseiten der Winkelschenkel 40) je einen Anlagewinkel (41) für den Schraubkanal (10) und das daran zum Gehäuse-Innenraum anschließende U-Profil (18) zeigt, wobei in jedem der beiden Anlagewinkel (41) zwei rechtwinklig zueinander stehende Durchstecklöcher (42) für die in die Schraubkanäle (10) der Außenprofile (7,8) eingreifenden Schrauben(11) und Gewindebohrungen (49) vorgesehen sind.

11. Steuergehäuse nach einem der Ansprüche 1 bis 10, dadurch gekennzeichnet, daß in beiden Längenenden der Längsecken (3) in beiden Winkelschenkel-Außenseiten je eine zu den Längenenden hin offene Vertiefung (43) ausgespart ist, in der wahlweise ein Eckverbinder (44) zur Verbindung zweier aneinander gereihter Gehäuse (1) oder eines Gehäuses (1) und einer Tür (4), ein Scharnier (45) und einer dem Scharnier (45) im Gehäuse (1) gegenüberliegende Sicherungszunge (46) mittels Schrauben (47) festlegbar ist.

12. Steuergehäuse nach einem der Ansprüche 1 bis 11, dadurch gekennzeichnet, daß das Eckstück (38) der Tür (4) von einem Eckwinkel mit im Querschnitt T-förmigen Winkelschenkeln (48) gebildet ist, dessen freiendseitige T-Flächen in sich ebene Anlageflächen (48a) für den Schraubkanal (10) und das sich daran in Richtung Tür-Innenraum anschließende U-Profil (18) ergeben, in dessen Winkelschenkeln (48) außenseitig Vertiefungen (43) für das Einsetzen eines Scharnieres (45) einer Sicherungszunge (46) oder eines Eckverbinders (44) ausgeformt sind und dessen Winkelschenkel (48) von in Schenkel-Längsrichtung verlaufenden, rechtwinklig zueinander stehenden Durchgangslöcher (42) für die Schrauben (11) zur Eckstück-Türprofil-Verbindung und Gewindebohrungen (49) für die Befestigung des Scharnieres (45), der Sicherungszunge (46) und des Eckverbinders (44) ausgenommen sind.

13. Steuergehäuse nach einem der Ansprüche 1 bis 12, dadurch gekennzeichnet, daß die Längsecke (3) in ihren beiden Längenendbereichen und das Eckstück (38) außenseitig von einer winkelförmigen Eckklappe (50) überdeckt ist, welche in Vertiefungen (51) der Längsecke (3) und des Eckstückes (38) außen bündig liegend eingesetzt ist, mit randseitigen Abwinklungen (52) in Nuten (53) und/oder in die Vertiefungen (43) der Längsecke (3) und des Eckstückes (38) eingreift und entsprechend dem Einsatz von Scharnier (45), und zwar dessen Außengelenkes, in ihren Winkelschenkeln (50a) und/oder Abwinklungen (52) abtrennbar ist.

14. Steuergehäuse nach einem der Ansprüche 1 bis 13, dadurch gekennzeichnet, daß die Längsecke (3) und das Eckstück (38) jeweils einstückig als Gußteil aus Aluminium hergestellt ist und an ihrer Außenecke abgerundet sind.

15. Steuergehäuse nach einem der Ansprüche 1 bis 14, dadurch gekennzeichnet, daß die Eckklappen (50) einstückig aus Kunststoff bestehen, an beiden Seiten beider Winkelschenkel (50a) mit je einer lappenförmigen Abwinklung (52) ausgestaltet und zwischen diesen vier Abwinklungen (52) in Breite der Schenkel (50a) durch beidseitige Aussparungen (54) verringert sind, wobei die schmalen Schenkelbereiche (50c) in die Vertiefungen (51) der Längsecke (3) und des Eckstückes (38) passend eingesetzt, die breiteren Schenkelbereiche (50a) in die Vertiefung (51) in Richtung Anlageflächen (48a) die gesamte Breite des Eckstückes (38) bzw. den Endbereich der Längsecke (3) überdeckend einfassen und mit ihren Abwinklungen (52) in die Nuten (53) eingesteckt sind sowie mit den Abwinklungen (52) in die freiendseitigen Stirnenden der Vertiefungen (43) der Längsecke (3) bzw. des Eckstückes (38) einfassen, wodurch der gesamte ausgesparte Außenbereich der Längsecke (3) und des Eckstückes (38) geschlossen ist.

16. Steuergehäuse nach einem der Ansprüche 1 bis 15, dadurch gekennzeichnet, daß in der Tür (4) und dem Grundgehäuse (1) eine Klarsichtscheibe (56), Frontplatte (56) oder Rückwand (56) einsetzbar ist, welche an dem U-Profil (18) des Außenprofiles (7,8) oder des Türprofiles (37) und an einer Seite des Anlagewinkels (41) vom Eckstück (38) bzw. Längsecke (3) an dem gebildeten, umlaufenden Tür- oder Gehäuserahmen anliegt und durch mehrere auf dem Umfang des Bauteiles (56)angeordnete Klemmstücke (60) gehalten ist.

17. Steuergehäuse nach einem der Ansprüche 1 bis 16, dadurch gekennzeichnet, daß jedes Klemmstück (60) von einem profilierten mit einer gegen die Scheibe, Frontplatte oder Rückwand (56) drückenden ersten Plattenkante (60a) ausgestatteten und mit einer wulstartigen zweiten Plattenkante (60b) in einer Lagerrinne (59) des Außen- oder Türprofiles (7,8/37) lagefixiert eingreifenden Plattenteil gebildet ist, welches durch jeweils mindestens eine in ein in die Montagenuten (17) von Außen- oder Türprofil eingeschobene Mutter (57) einfassende Schraube (58) in der Spannstellung gehalten ist (Fig. 12).

18. Steuergehäuse nach einem der Ansprüche 1 bis 17, dadurch gekennzeichnet, daß die Klarsichtscheibe (56), die Frontplatte (56) oder die Rückwand (56) und die Klemmleiste (60) umlaufend von einem Abdeckrahmen (61) abgedeckt ist und dieser Abdeckrahmen (61) Deckprofile (62) aus Kunststoff aufweist, welche schrägliegend mit einem Haltehaken (63) in die Nut (19) vom Außen- bzw. Türprofil (7,8/37) eingreifen und mit einer Rastnase (64) hinter eine Gegennase (65) der Klemmstücke (60) verrasten (Fig. 12) und dieser Abdeckrahmen (61) in den Eckstößen der Deckprofile (62) Abdeckecken (66) aus Kunststoff zeigt, die mit einem Steckwinkel (66a) in je eine im Innenwinkel-Scheitelpunkt ausgesparte Nut (67) von Eckstück (38) und Längsecke (3) eingesteckt sind, mit den Deckprofilen (62) bündig zusammenstoßen und mit angeformten Lappen (66b) unter die Deckprofile (62) greifen (Fig. 1 bis 13).

19. Steuergehäuse nach einem der Ansprüche 1 bis 18, dadurch gekennzeichnet, daß für die schwenkbare Verbindung von Tür (4)/Tür (4) oder Tür (4)/Grundgehäuse (1) oder Grundgehäuse (1)/Grundgehäuse (1) ein Hakenverschluß (68) vorgesehen ist, der in eine Aussparung (69) der Außenwand (12) des Türprofiles (37) bzw. des Außenprofiles (7,8) eingesetzt ist und der einen aus einer Aussparung (70) in dem Längsrand (13) von Tür- oder Außenprofil (7,8,9) herausbewegbaren und in eine entsprechende Aussparung (71) des Längsrandes (13) der benachbarten Tür (4) oder Grundgehäuse (1) eingreifenden Verschlußhaken (72) aufweist, welcher von einem Knebelgriff (73) oder einem Schließdorn (74) mit Abdeckkappe (75) um einen Exzenter (76) verschwenkbar ist und dabei die benachbarten Bauteile (4 und 1) mit ihren Profil-Längsrändern (13) zusammenzieht (Fig. 1, 19 bis 22).

## Claims

1. A control housing for receiving electrical, electronic and mechanical components, which consists of at least one basic housing comprising four walls and corner connectors to hold these together, and of at least one door (frame) mounted fixedly or pivotably on the basic housing, characterised in that each wall (2) of the basic housing (1) is formed from at least two profiles (7, 8, 9) which are held together at their longitudinal edges by snap-lock connections (5, 6) and which are connected by four elongate corners (3) each applied between two end faces of the profiles (7, 8, 9) and arranged at right-angles to one another and a plurality of screws (11) penetrating the elongate corners (3) and engaging in screw channels (10) in the profiles (7, 8, 9).

2. Control housing according to claim 1, characterised in that the basic housing (1) consists, for the formation of the housing walls (2) and variable depths of housing, of two outer profiles (7, 8) or two outer profiles (7, 8) and one or more central profiles (9) disposed therebetween, which extend longitudinally along the height and breadth of the housing, and wherein the two outer profiles (7, 8) are connected together or the central profiles (9) are connected together and to the outer profiles (7, 8) by snap-lock connectors (5, 6), and the outer profiles (7, 8) each have a screw channel (10) for connecting the housing walls (2) to the elongate corners (3) by way of screws (11).

3. Control housing according to claim 1 or 2, characterised in that the outer profile (7, 8) is formed as a hollow profile with an outer wall (12) which is plane *per se,* two longitudinal edges (13, 14) projecting therefrom, an inner wall section (15) extending parallel to the outer wall (12) and supported on the inner longitudinal edge, and a profile section (16) projecting from the outer longitudinal wall (13) and the inner wall section (15), and at the same time the profile section (16) has an assembly groove (17) with an undercut cross-section, which projects obliquely outwards and which is open to the vertical, outer longitudinal edge (13), a screw channel (10) which is disposed at a distance adjacent to the assembly groove (17), is undercut in cross-section and is open to the cavity of the outer profiles (7, 8), a U-profile (18) projecting from the screw channel (10) towards the housing interior and open in the direction of the outer longitudinal edge (13), and a groove (19) which is set back with respect to the outer longitudinal edge (13), lies in front of the assembly groove (17), and is open towards the outside.

4. Control housing according to one of claims 1 to 3, characterised in that one outer profile (7) has on its inner, preferably oblique longitudinal edge (14) an outer locating strip (20) forming an extension of the outer wall (12) and comprising a locating lug (21) on its free end and an inner holding strip (22) extending at a parallel distance from the inner wall section (15) and parallel to the outer locating strip (20) and comprising at its free end a holding bracket (23), which forms, with a web (24) forming an extension of the inner wall section (15) and projecting beyond the inner longitudinal edge (14), an insertion groove (25), and in that the second outer profile (8) has on its inner, preferably vertical longitudinal edge (14) an outer, hook-like locating strip (26) forming an extension of the outer wall (12) and comprising a locating lug (27) and an inner insertion strip (28) forming an extension of the inner wall section (15), extending beyond the outer locating strip (26), and comprising a stepped holding bracket (29) at its free end and an abutment web (30) projecting from the insertion strip (26) at a distance in front of the holding bracket (29), wherein for the snap-lock connection the holding bracket (29) and abutment web (30) engage in the insertion groove (25) of the first outer profile (7), and at the same time the holding bracket (29) engages under the web (24) and the abutment web (30) lies in front of the holding bracket (23), and the locating strip (26) is hooked with its locating lug (27) behind the locating lug (21) of the second locating strip (20).

5. Control housing according to one of claims 1 to 4, characterised in that the central profile (9) is formed from a hollow plate element with an outer and inner wall (33, 34), which are plane *per se* and are held at a parallel distance from one another by a vertical and an oblique longitudinal edge (31, 32), and has at its two longitudinal edges (31, 32) the snap-lock means (20 to 30) provided for connecting adjacent central profiles (9) and comprising the outer profiles (7, 8).

6. Control housing according to one of claims 1 to 5, characterised in that on the inner wall section (15) of the first outer profile (7) one, and on the inner wall section (15) of the second outer profile (8) and of the inner wall (34) of the central profile (9) a plurality of, profile strips (35) of preferably T-shaped cross-section are integrally formed, these profile strips forming assembly grooves (36) with an undercut cross-section for the components to be accommodated in the housing.

7. Control housing according to one of claims 1 to 6, characterised in that the door (4) has a frame formed from four door profiles (37) and four corner members (38) each applied between two end faces of the door profiles (37) disposed at right-angles to one another, and a plurality of screws (11) engaging in a screw channel (10) of each door profile (37).

8. Control housing according to one of claims 1 to 7, characterised in that the door profile (37) is formed as a hollow profile of trapezoid cross-section with an outer wall (12) which is plane *per se,* two longitudinal edges (13, 14) projecting therefrom and standing perpendicular to the outer wall (12), and a profile section (16) projecting therefrom, wherein the profile section (16) has on the longitudinal edge side a groove (19) extending from the outer longitudinal edge (13) to the profile centre, obliquely away from the outer wall (13), an assembly groove (17) with an undercut cross-section, a screw channel (10) open to the profile cavity, and a U-profile (18) thereabove which is open to the outside, and adjacent to the inner longitudinal edge (14) a second U-profile (39) open to the door profile inner face.

9. Control housing according to one of claims 1 to 8, characterised in that the door profile (37), the two outer profiles (7, 8) and the central profile (9) are formed as one-part aluminium extruded profiles.

10. Control housing according to one of claims 1 to 9, characterised in that the elongate corner (3) of each wall (2) formed by the profiles (7, 8, 9) is formed from an bracket profile which extends over the entire depth of the housing and whose free arm faces at right-angles to one another of the two bracket arms (40) form contact faces (40a) which are plane *per se* for the profile end faces, and which has at a distance from its two longitudinal ends in the female angle (inner faces of the bracket arms 40) a respective contact angle (41) for the screw channel (10) and the adjacent U-profile (18) adjoining the housing interior, wherein in each of the two support brackets (41), two through apertures (42) at right-angles to one another are provided for the screws (11) and threaded bores (49) engaging in the screw channels (10) of the outer profiles (7, 8).

11. Control housing according to one of claims 1 to 10, characterised in that in both longitudinal ends of the elongate corners (3), in the outer faces of both bracket arms, a respective recess (43) open to the longitudinal ends is formed, in which selectively a corner connector (44) for connecting two housings (1) joined in sequence or connecting a housing (1) and a door (4), a hinge (45) and a safety tongue (46) opposite the hinge (45) in the housing (1) is fixable by means of screws (47).

12. Control housing according to one of claims 1 to 11, characterised in that the corner member (38) of the door (4) is formed by a corner bracket with bracket arms (48) of T-shaped cross-section, their T-faces at the free end producing contact faces (48a) which are plane *per se* for the screw channel (10) and the U-profile (18) abutting the screw channel in the direction of the door interior, in whose bracket arms (48), on the exterior, recesses (43) for the insertion of a hinge (45) of a safety tongue (46) or of a corner connector (44) are formed and whose bracket arms (48) are taken out of through apertures (42) extending in the arm longitudinal direction and arranged at right-angles to one another for the screws (11) for corner member-door profile connection and threaded bores (49) for fixing the lock (45), the safety tongue (46) and the corner connector (44).

13. Control housing according to one of claims 1 to 12, characterised in that the elongate corner (3) is covered in both longitudinal end regions and the corner member (38) is covered on the exterior by a bracket-shaped corner flap (50), which is inserted in recesses (51) of the elongate corner (3) and of the corner member (38) so as to be flush with the exterior, engages with edge bent-back members (52) in grooves (53) and/or in the recesses (43) of the elongate corner (3) and of the corner member (38), and corresponding to the use of a hinge (45), in particular its outer joint, is separable at its bracket arms (50a) and/or bent-back members (52).

14. Control housing according to one of claims 1 to 13, characterised in that the elongate corner (3) and the corner member (38) are each formed in one piece as an aluminium casting and are rounded on their outer corner.

15. Control housing according to one of claims 1 to 14, characterised in that the corner flaps (50) are formed in one piece from plastics material, are formed on both sides of both bracket arms (50a) with a respective member (52) bent back to form a tab, and between these four bent-back members (52) are reduced in width of the arms (50a) by bilateral recesses (54), the narrow arm regions (50c) being inserted as a fit in the recesses (51) of the elongate corner (3) and of the corner member (38), the wider arm regions (50a) engaging in the recess (51) in the direction of contact faces (48a) so as to cover the entire width of the corner member (38) or the end region of the elongate corner (3), whereby the entire recessed outer region of the elongate corner (3) and of the corner member (38) is closed.

16. Control housing according to one of claims 1 to 15, characterised in that in the door (4) and the basic housing (1) an inspection glass (56), front plate (56), or rear wall (56) is insertable, which abuts the U-profile (18) of the outer profile (7, 8) or of the door profile (37) and one side of the support bracket (41) of the corner member (38) or elongate corner (3) on the formed, surrounding door or housing frame and is held by a plurality of clamping members (60) disposed on the circumference of the component (56).

17. Control housing according to one of claims 1 to 16, characterised in that each clamping member (60) is formed by a profiled plate part equipped with a first plate edge (60a) pressing against the glass, front plate or rear wall (56) and engaging in a fixed position by a bulge-like second plate edge (60b) in a bearing groove (59) of the outer or door profile (7, 8/37), which is held in the clamping position by at least one screw (58) engaging in a nut (57) inserted in the assembly grooves (17) by the outer or door profile (Fig. 12).

18. Control housing according to one of claims 1 to 17, characterised in that the inspection glass (56), the front plate or the rear wall (56) and the clamping strip (60) is covered continuously by a cover frame (61), and this cover frame (61) has cover profiles (62) composed of plastics material, which engage obliquely with a holding hook (63) in the groove (19) of the outer or door profile (7, 8/37) and engage with a locating lug (64) behind a counter-lug (65) of the clamping members (60) (Fig. 12), and this cover frame (61) has in the corner joints of the cover profiles (62) plastics cover corners (66), which are inserted with an insertion bracket (66a) in a respective groove (67) recessed in the female angle apex of the corner member (38) and elongate corner (3), are pushed together flush with the cover profiles (62) and engage with integrally formed tabs (66b) under the cover profiles (62) (Fig. 1 to 13).

19. Control housing according to one of claims 1 to 18, characterised in that for the pivoting connection between door (4)/ door (4) or door(4)/ basic housing (1) or basic housing (1)/basic housing (1) a hook lock (68) is provided, which is inserted in a recess (69) in the outer wall (12) of the door profile (37) or of the outer profile (7, 8) and which has a lock hook (72) capable of moving out of a recess (70) in the longitudinal edge (13) of the door or outer profile (7, 8, 9) and engages in a corresponding recess (71) in the longitudinal edge (13) of the adjacent door (4) or basic housing (1), and which is pivotable by a locking handle (73) or a closing pin (74) with a cover cap (75) about a cam (76), and thus draws together the adjacent components (4 and 1) with their profile longitudinal edges (13) (Fig. 1, 19 to 22).

## Revendications

1. Boîtier de contrôle pour composants électriques, électroniques et mécaniques composé d'au moins un carter de base présentant quatre parois et des éléments d'assemblage angulaires et, d'au moins, une porte (cadre) fixe ou pivotante équipant le boîtier de base,
caractérisé en ce que
chaque paroi (2) du carter de base (1) est formée d'au moins deux profilés (7, 8, 9), maintenus ensemble, par leurs bords longitudinaux, à l'aide d'éléments de raccordement et d'arrêt (5, 6), les profilés (7, 8, 9) étant reliés par des pièces d'angle longitudinales (3), disposées, chacune, à angle doit par rapport l'une à l'autre, entre deux extrémités frontales des profilés (7, 8, 9), et par plusieurs vis (11) traversant les pièces d'angle longitudinales (3) et mordant dans des canaux de vissage (10) qui équipent les profilés (7, 8, 9).

2. Boîtier de contrôle selon la revendication 1,
caractérisé en ce que,
pour former les parois (2) du boîtier et assurer des profondeurs de boîtier variables, le carter de base (1) est composé de deux profilés extérieurs (7, 8) ou de deux profilés extérieurs (7,8) et d'un ou plusieurs profilés médians (9), insérés entre les premiers, les profilés médians (9) étant disposés de sorte que leur longueur s'étende à la hauteur et sur la largeur du boîtier et les deux profilés extérieurs (7, 8) étant reliés ensemble, resp.:les profilés médians (9) étant reliés entre eux et avec les profilés extérieurs (7, 8) à l'aide de dispositifs d'arrêt enfichables (5, 6) et les profilés extérieurs (7, 8) étant équipés, chacun, d'un canal de vissage (10) pour le raccordement des parois (2) aux pièces d'angle longitudinales (3), à l'aide de vis (11).

3. Boîtier de contrôle selon la revendication 1 ou 2,
caractérisé en ce que
les profilés extérieurs (7, 8) sont conçus sous forme de profilés creux avec une paroi extérieure plane (12), deux bords longitudinaux (13, 14) en saillie de celle-ci, un secteur de paroi intérieur (15) qui prend appui sur le bord longitudinal, intérieur et s'étend parallèlement à la paroi extérieure (12), et un secteur de profilé (16) en saillie du bord longitudinal, extérieur (13) et du secteur de paroi intérieur (15), le secteur de profilé (16) étant pourvu d'une rainure de montage (17) contredépouillée dans sa section transversale, disposée obliquement vers l'extérieur et ouverte vers le bord longitudinal, extérieur, vertical (13), d'un canal de vissage (10) contredépouillé dans sa section transversale, disposé, à intervalle, à côté de la rainure de montage (17), et ouvert vers la cavité du profilé (7, 8), d'un profilé en U (18), s'élevant au-dessus du canal de vissage (10) et, dirigé vers l'intérieur du boîtier, ouvert en direction du bord longitudinal, extérieur (13), ainsi que d'une rainure ouverte vers l'extérieur(19), disposée en retrait par rapport du bord longitudinal, extérieur (13) et en amont de la rainure de montage (17).

4. Boîtier de contrôle selon l'une des revendications 1 à 3,
caractérisé en ce que
le profilé extérieur (7) est pourvu, sur son bord longitudinal, intérieur, préférentiellement oblique, (14) d'une barre d'arrêt externe (20), s'étendant en prolongement de la paroi extérieure (12) et équipée d'un taquet (21) à extrémité libre, et d'une barre de retenue interne (22) parallèle au secteur de paroi intérieur (15) et à la barre d'arrêt externe (20), laquelle barre de retenue interne (22) est équipé d'une pièce de retenue angulaire (23) à extrémité libre et forme une rainure d'enfichage (25) à l'aide d'une languette (24) qui prolonge le secteur de paroi intérieur (15) et fait saillie au-dessus du bord longitudinal, intérieur (14),
et que le deuxième profilé extérieur (8) est pourvu, sur son bord longitudinal, intérieur, préférentiellement vertical (14), d'une barre d'arrêt externe (26), genre crochet, s'étendant en prolongement de la paroi extérieure (12) et équipée d'un taquet (27), et d'une barre d'insertion interne (28), qui, prolongeant le secteur de paroi intérieur (15) et faisant saillie par rapport à la barre d'arrêt externe (26), présente une pièce de retenue angulaire, dégradée (29) à extrémité libre et une languette de butée (30) disposée, à intervalle de la pièce de retenue angulaire (29), verticalement, en direction de la barre d'arrêt externe (26) et en saillie de la barre d'insertion (29), le raccorement d'arrêt se faisant par enclenchement de la pièce de retenue angulaire (29) et de la languette de butée (30) dans la rainure d'insertion (25) du premier profilé (7) et que, ce faisant, la pièce de retenue angulaire(29) s'engage sous la languette (24) alors que la languette de butée (30) se trouve devant la pièce de retenue angulaire (23) et la barre d'arrêt (26) est accrochée par son taquet (27) derrière le taquet (21) de la deuxième barre d'arrêt (20).

5. Boîtier de contrôle selon l'une des revendications 1 à 4,
caractérisé en ce que
le profilé médian (9) est formé par un élément creux à paroi extérieure et paroi intérieure (33, 34), planes en elles-mêmes, et reliées, parallèlement, à intervalle l'une de l'autre, par un bord longitudinal vertical et un bord longitudinal oblique (31, 32), et qu'il présente , sur ses deux bords longitudinaux (31, 32), des auxiliaires d'arrêt enfichables et encliquetables (20 à 30), prévus pour l'assemblage de profilés médians (9), voisins et leur raccordement aux profilés extérieurs (7, 8).

6. Boîtier de contrôle selon l'une des revendications 1 à 5,
caractérisé en ce que
plusieurs baguettes profilées (35), présentant, de préférence, une section transversale en T et équipées de rainures (36) contredépouillées en section transversale et destinées au montage des composants à loger dans le boîtier, sont formées à partir du secteur de paroi intérieure (15) du premier profilé extérieur (7) et de la paroi intérieure (34) du profilé médian (9).

7. Boîtier de contrôle selon l'une des revendications 1 à 6,
caractérisé en ce que
la porte (4) présente un cadre formé de quatre profilés de porte (37) et de quatre goussets (38) installés, chacun, entre deux extrémités frontales, formant angle droit, des profilés de porte (37) et de plusieurs vis (11) qui traversent les goussets (38) et mordent dans un canal de vissage (10) de chaque profilé de porte (37).

8. Boîtier de contrôle selon l'une des revendications 1 à 7,
caractérisé en ce que
le profilé de porte (37) est un profilé creux de section transversale trapézoïdale, avec une paroi extérieure (12), deux bords longitudinaux (13, 14) se dressant sur cette dernière, perpendiculairement à celle-ci, et un secteur de profilé (16) y faisant saillie, le secteur de profilé (16) présentant une rainure marginale, longitudinale (19), qui s'étend, en biais, du bord longitudinal, extérieur (13) vers le centre du profilé, une rainure de montage (17) de section transversale contredépouillée, un canal de vissage (10) ouvert vers la cavité du profilé, et, au-dessus de celui-ci, un profilé en U (18), ouvert vers l'extérieur, ainsi qu'un deuxième profilé (39) en U, ouvert vers le côté intérieur du profilé de porte et situé à côté du bord longitudinal, intérieur (14).

9. Boîtier de contrôle selon l'une des revendications 1 à 8,
caractérisé en ce que le profilé de porte (37), les deux profilé extérieurs (7, 8) et le profilé médian (9) sont des profilés en aluminium, filés d'une pièce.

10. Boîtier de contrôle selon l'une des revendications 1 à 9,
caractérisé en ce que
la pièces d'angle longitudinales (3) consiste en une cornière qui s'étend sur la profondeur totale du boîtier - de chacune des parois (2) formées par les profilés (7, 8, 9) -, les surfaces libres, disposées à angle droit, des deux ailes (40) de la cornière formant des surfaces d'appui planes (40a) pour les surfaces frontales des profilés, et présentant, à intervalle de chacune de ses deux extrémités longitudinales, dans l'angle intérieur (côtés intérieurs des branches de la cornières 40), un angle d'appui (41) pour le canal de viissage (10) et le profilé en U (18) y faisant suite, en direction de l'intérieur du bâti, deux trous de passage (42), disposés à angle droit par rapport l'un à l'autre, étant prévus dans chacun des angles d'appui (41) pour les vis (11) et les taraudages (49) mordant dans les canaux de vissage (10) des profilés exctérieurs (7, 8).

11. Boîtier de contrôle selon l'une des revendications 1 à 10,
caractérisé en ce que,
dans chacune des deux extrémités longitudinales des pièces d'angle longitudinales (3), sur les deux côtés extérieurs des branches de l'angle, une cavité (43), ouverte vers les extrémités longitudinales, est pratiquée, cavité (43) dans laquelle on peut fixer, au choix, un raccord en cornière (44) pour assembler, à l'aide de vis (47), deux carters de base (1) ou un carter de base (1) et une porte (4), une charnière (45) et une languette de sûreté (46) lui faisant face dans le carter de base (1).

12. Boîtier de contrôle selon l'une des revendications 1 à 11,
caractérisé en ce que
la pièce d'angle (38) de la porte (4) est formée par une cornière dont la section transversale des branches (48) est en T et les surfaces des extrémités libres du T formant des surfaces d'appui planes (48a) pour le canal de vissage (10) et le profilé en U (18) y faisant suite, en direction de l'intérieur de la porte, des cavités (43) étant pratiquées, à l'extérieur, dans les branches de la cornière (48), pour insérer une charnière (45), une languette de sûreté (46) ou un raccord angulaire (44), et les ailes de la cornières (48) étant pourvues de trous de passage (42), disposés à angle droit par rapport les uns aux autres, dans le sens longitudinal des ailes et destinés à la fixation de la charnière (45), de la languette de sûreté (46) et du raccord angulaire (44).

13. Boîtier de contrôle selon l'une des revendications 1 à 12,
caractérisé en ce que
les deux zones d'extrémité de la pièce d'angle longitudinale (3) et le côté extérieur de la cornière (38) sont recouverts d'un volet coudé (50) qui est inséré, affleuré à l'extérieur, dans des cavités (51) de la pièce d'angle longitudinale (3) et de la cornière (38) et s'engage, par des pièces pliées (52), dans des rainures (53) et/ou les cavités (43) de la pièce d'angle longitudinale (3) et peut être sectionnée, dans ses ailes (%=A) et/ou ses pièces pliées (52) selon l'installation d'une charnière (45), en l'occurence de son articulation extérieure.

14. Boîtier de contrôle selon l'une des revendications 1 à 13,
caractérisé en ce que
la pièce d'angle longitudinale (3) et la cornière (38) sont exécutées, chacune, d'une pièce, en tant que pièces coulées en aluminium, et présentent des coins extérieurs arrondis.

15. Boîtier de contrôle selon l'une des revendications 1 à 14,
caractérisé en ce que
les volets coudés (50) sont exécutés d'une pièce, en matière plastique, que les deux côtés des deux ailes (590a) sont pliés, chacun, en genre d'oreille (52) et sont réduits, entre ces quatre plis (52), dans la largeur des ailes (50a), par des évidements bilatéraux (54), les zones étroites (50c) étant insérées, bien adaptées, dans les cavités (51) de la pièce d'angle longitudinale (3) et de la cornière (38), tandis que les zones plus larges (50a) s'engagent dans la cavité (51), en direction des surfaces d'appui (48a) en couvrant toute la largeur de la cornière (38) resp. la zone d'extrémité de la pièce d'angle longitudinale (3), et sont insérées, par leurs parties pliées (52) dans les rainures (52) et dans les extrémités frontales, libres des cavités (43) de la pièced'angle longitudinale (3) et de la cornière (38) de sorte que la totalité de la zone extérieure évidée de la pièce d'angle longitudinale (3) et de la cornière (38) se trouve fermée.

16. Boîtier de contrôle selon l'une des revendications 1 à 15,
caractérisé en ce que,
dans la porte (4) et le carter de base (1), une vitre, une plaque transparente (56), un panneau frontal (56) ou une paroi arrière (56) peut être inséré, lequel porte contre le profilé en U (18) du profilé extérieur (7, 8) ou du profilé de porte (37) et sur un côté de l'angle d'appui (41) de la cornière (38) resp. de la pièce d'angle longitudinale (3), contre le cadre continu de la porte ou du carter, et est maintenu par plusieurs éléments de serrage (60) répartis sur le pourtour cette pièce (56).

17. Boîtier de contrôle selon l'une des revendications 1 à 16,
caractérisé en ce que
chaque élément de serrage (60) est pourvu d'un premier bord (60a) profilé appuyant sur la vitre, le panneau ou le dos (56) et d'un deuxième bord (60b) en forme de boudin s'ancliquetant, positionné fixement, dans un conduit de montage (59) du profilé extérieur ou du profilé de porte (7, 8/37) qui est maintenu en position de tension, au moins, par une vis (58) mordant dans un écrou (57) enfoncé dans une rainure de montage (17) du profilé extérieur ou de porte (Fig. 12).

18. Boîtier de contrôle selon l'une des revendications 1 à 17,
caractérisé en ce que
la vitre ou plaque transparente (56), le panneau frontal (56) ou le dos (56) et la baguette de serrage (60) sont recouverts, en continu, par un cadre de couverture (61) et que ce cadre de couverture (61) présente des profilés de couverture (62) en matière plastique qui, disposés en diagonale, s'engagent, avec un crochet de retenue (63), dans la rainure (19) du profilé extérieur ou de porte (7, 8/37), et prennent l'encoche, à l'aide d'un taquet (64), derrière un contre-taquet (65) de la baguette de serrage (fig. 12), et que ce cadre de couverture (61) présente, dans les joints d'angles des profilés de recouvrement (62), des cornières de recouvrement (66) en matière plastique qui sont insérées, chacune, par une fiche angulaire (66a), dans une rainure (67) pratiquée au sommet de la cornière (38) et de la pièce d'angle longitudinale (3), sont jointes, à fleur, aux profilés de recouvrement (62) et dont les oreilles (66b), formant corps avec elles, s'engagent sous les profilés de couverture (62) (fig. 1 à 13).

19. Boîtier de contrôle selon l'une des revendications 1 å 18,
caractérisé en ce que,
pour le raccordement porte (4)/porte (4) ou porte (4) /carter de base (1) ou carter de base (1)/carter de base (1), un fermeture à crochet (68) est prévue, laquelle est insérée dans un évidement (69) de la paroi extérieure (12) du profilé de porte (37) ou du profilé extérieur (7, 8) et présente un crochet de fermeture (72), qui peut être mû hors de l'évidement (70), pratiqué dans le bord longitudinal (13) du profilé de porte ou extérieur (7, 8, 9), et qui s'engage dans un évidement approprié (71) du bord longitudinal (13) de la porte voisine (4) ou du carter de base (1), ce crochet de fermeture (72) pouvant être pivoté, avec un capuchon de couverture (75), autour d'un excentrique (76), à l'aide d'une manette ou d'une broche, et tirant ainsi les éléments voisins (4 et 1) l'un vers l'autre, en rapprochant les bords longitudinaux (13) des profilés. (fig. 1, 19 à 22).
